# FASCICULE DE BREVET EUROPEEN

(11) **EP 3 948 906 B1**
(45) Date de publication et mention de la délivrance du brevet: **20.05.2026**
(21) Numéro de dépôt: 20715098.8
(22) Date de dépôt: 03.04.2020
(51) Int. Cl.: H01G 2/04, H01G 2/10, H01G 11/08, H01G 11/82, H05K 7/14

(54) **BLOC CAPACITIF COMPRENANT UN CADRE EN MATERIAU ELECTRIQUE ISOLANT**
KAPAZITIVER BLOCK MIT EINEM RAHMEN AUS ELEKTRISCH ISOLIERENDEM MATERIAL
CAPACITIVE BLOCK COMPRISING A FRAME OF ELECTRICALLY INSULATING MATERIAL

(30) Priorité: 05.04.2019 FR 1903711
(43) Date de publication de la demande: 09.02.2022
(73) Titulaire: Valeo Electrification, 95800 Cergy (FR)
(72) Inventeur: GILET, Olivier, 95800 CERGY (FR); LAMARCHE, Anthony, 95800 CERGY (FR)
(74) Mandataire: Valeo Powertrain Systems
(86) Numéro de dépôt international: PCT/EP2020/059642
(87) Numéro de publication internationale: WO 2020/201543

(56) Documents cités:
- EP-A1- 2 562 811
- WO-A1-2013/113691
- WO-A1-2015/128571
- US-A1- 2002 051 335
- US-A1- 2014 168 901
- US-A1- 2018 233 285

## Description

La présente invention concerne un bloc capacitif, notamment pour un équipement électrique, par exemple embarqué dans un véhicule automobile, notamment électrique ou hybride. Un tel équipement électrique peut être un onduleur, un convertisseur de tension ou un chargeur électrique de batterie.

Comme cela est connu, dans un bloc capacitif, un élément capacitif peut être disposé dans un boîtier et noyé dans un matériau de remplissage assurant principalement une fonction de maintien et de protection de l'élément capacitif vis-à-vis de l'humidité. Un tel matériau de remplissage se présente généralement sous la forme d'une résine. L'élément capacitif est par exemple constitué de films enroulés autour des bornes de la capacité. Typiquement, l'élément capacitif est intégralement noyé dans la résine de sorte que l'extérieur du bloc capacitif est formé par des parois externes du boitier et une face formée par la résine. Seules des bornes électriques s'étendent à l'extérieur de la résine depuis ladite face. Cependant, dans certaines applications, en particulier dans des véhicules électriques ou hybrides, on cherche à diminuer l'encombrement des composants électroniques. Or, dans cette structure de bloc capacitif, le boitier et la résine occupent un espace qui peut être non négligeable. En outre, il est nécessaire de laisser un espace entre l'élément capacitif et les parois latérales du boitier pour permettre un écoulement de la résine avant son durcissement.

On connait un bloc capacitif dans lequel le boitier s'étend sur une hauteur inférieure à la hauteur de l'élément capacitif. Le boitier forme alors une cuvette juste suffisante pour recevoir de la résine au niveau d'une première extrémité du bloc capacitif qui comprend la connexion électrique entre une borne électrique du bloc capacitif et une électrode de l'élément capacitif.

Dans une telle structure, l'encombrement du bloc capacitif est limité du fait de la faible hauteur du boitier. Cependant, dans une telle structure de bloc capacitif, la portion de l'élément capacitif qui est hors de la résine n'est pas protégée contre un environnement extérieur du bloc capacitif. Notamment, lorsqu'une plaque conductrice électrique est fixée sur une deuxième extrémité de l'élément capacitif opposée à la première extrémité, la plaque électrique n'est à priori pas isolée par rapport à un environnement proche.

L'état de la technique pertinent pour la présente invention se trouve en plus dans les publications US 2002/051335 A1, US 2014/168901 A1 et EP 2 562 811.

Il existe donc un besoin pour protéger électriquement les éléments d'un bloc capacitif qui ne sont pas par ailleurs protégés par une résine.

A cet effet, l'invention concerne un bloc capacitif comprenant :
au moins un élément capacitif ;
un premier conducteur électrique comprenant au moins une plaque conductrice électrique venant contre une première extrémité de l'élément capacitif de manière à être connectée électriquement avec l'élément capacitif ;un premier cadre en matériau isolant électrique venant en correspondance avec un bord périphérique de la dite plaque conductrice de manière à isoler électriquement ladite plaque par rapport à un environnement du bloc capacitif.

En venant contre les bords de la plaque conductrice, le premier cadre empêche le passage d'un courant électrique entre un élément conducteur électrique proche du bloc capacitif, à travers l'air et/ou le long d'une ligne de fuite.

Selon un mode de réalisation, ledit premier cadre comprend une première portion configurée pour venir contre une face de la plaque conductrice électrique et une deuxième portion s'étendant transversalement depuis ladite première portion de manière à former une jupe autour de ladite plaque conductrice. Ainsi, la jupe forme une barrière isolante électrique vis-à-vis d'éléments situés à proximité de la plaque conductrice. Notamment, la jupe vient en vis-à-vis des bords de ladite plaque conductrice. En particulier, la face contre laquelle vient la première portion est opposée à la première extrémité de l'élément capacitif.

Selon une variante, ladite jupe s'arrête à une hauteur inférieure à la moitié, voire au tiers ou au quart de la hauteur de l'élément capacitif depuis la première extrémité. Ainsi, la jupe ne s'étend pas sur toute la hauteur de l'élément capacitif. Ce qui limite l'encombrement du bloc capacitif.

Selon une variante, la jupe s'étend sur une distance depuis la première portion du premier cadre de sorte à éviter une circulation d'un courant électrique à travers l'air entre la plaque conductrice et un environnement du bloc capacitif.

Selon un mode de réalisation, ledit premier conducteur électrique comporte au moins une portion de connexion s'étendant depuis un bord périphérique de ladite plaque conductrice dans une direction transversale par rapport à ladite plaque conductrice, et ledit premier cadre comprend une portion de protection s'étendant vis-à-vis d'une face de ladite portion de connexion de manière à la protéger électriquement par rapport à un environnement du bloc capacitif. En particulier, ladite portion de protection s'étend parallèlement à ladite face de ladite portion de connexion.

Selon une variante, le premier conducteur électrique comprend une première portion de connexion qui s'étend en s'éloignant de l'élément capacitif, et ledit premier cadre comprend une première portion de protection qui s'étend depuis la première portion du premier cadre dans une direction opposée à celle de la jupe formée par la deuxième portion du cadre.

Selon une variante, le premier conducteur électrique comprend une deuxième portion de connexion qui s'étend depuis la plaque conductrice en vis-à-vis de l'élément capacitif, et ledit premier cadre comprend une deuxième portion de protection formée par au moins une partie de la jupe.

Selon un mode de réalisation, ledit premier cadre maintient au moins un deuxième conducteur électrique configuré pour venir sur le premier connecteur électrique de manière à connecter le premier conducteur électrique avec un composant électrique autre que l'élément capacitif, notamment avec un élément de filtrage d'une énergie électrique d'alimentation. Ainsi, le deuxième conducteur électrique est intégré dans le premier cadre. Le premier cadre a donc une fonction d'isolation électrique de la plaque conductrice, mais aussi, grâce au deuxième conducteur électrique, une fonction de connexion électrique entre le premier conducteur et un élément différent du bloc capacitif.

Selon une variante particulière, une extrémité d'une portion de connexion, notamment de la deuxième portion de connexion, est configurée pour venir sur une extrémité du deuxième conducteur électrique du premier cadre pour une connexion électrique.

Selon un mode de réalisation, le bloc capacitif comprend en outre un film isolant électrique en forme de cadre, venant continûment tout le long du bord interne du premier cadre et s'étendant radialement vers l'intérieur du premier cadre. Le film isolant permet notamment d'augmenter la ligne de fuite entre la plaque conductrice et un élément à proximité du bloc capacitif, notamment un élément situé en vis-à-vis de la plaque conductrice.

Selon un mode de réalisation, la plaque conductrice vient contre au moins une électrode de l'élément capacitif située à ladite première extrémité de l'élément capacitif pour y être connectée électriquement. En particulier, la connexion entre la plaque conductrice et l'électrode de l'élément capacitif est protégée par un vernis.

L'invention concerne en outre un équipement électrique, notamment configuré pour être embarqué dans un véhicule, comprenant un bloc capacitif selon l'invention, un module électronique de puissance et un circuit de refroidissement. La plaque conductrice du bloc capacitif vient contre une face du circuit de refroidissement ; et le module électronique de puissance vient contre une face opposée du circuit de refroidissement.

En particulier, le module électronique de puissance est un ensemble comprenant une pluralité de puces semi-conductrices formant un circuit électrique, lesdites puces étant encapsulées dans une même enveloppe. Plus précisément, le module électronique de puissance peut former un onduleur et comprend des composants par lesquels passe de l'énergie alimentant une machine électrique, par exemple un moteur électrique configuré pour entrainer un véhicule. Lesdits composants sont alors destinés à transformer un courant continu en courants alternatifs ou vice-versa. Un tel module électronique de puissance est notamment configuré pour permettre un passage commandé d'énergie électrique entre une batterie d'alimentation haute tension et la machine électrique.

Selon un mode de réalisation, l'équipement électrique comprend un bloc capacitif comprenant la première portion de connexion et la première portion de protection. La première portion de connexion se connecte directement aux bornes électriques du module électronique de puissance, en passant dans un passage formé au moins en partie par un bord du circuit de refroidissement. Et la première portion de protection dudit premier cadre s'étend dans ledit passage entre ladite première portion de connexion et ledit circuit de refroidissement. Ainsi, la première portion de protection du premier cadre réalise une isolation électrique entre la première portion de connexion du premier conducteur électrique et le circuit de refroidissement. La première portion de connexion évite notamment la formation d'un arc électrique dans l'air entre la première portion de connexion et le circuit de refroidissement.

Selon un mode de réalisation, l'équipement électrique comprend une couche de matériau isolant électriquement mais conducteur thermiquement entre le circuit de refroidissement et la plaque conductrice, ladite couche de matériau venant dans l'ouverture centrale du premier cadre. Ce matériau complète l'isolation électrique de la plaque conductrice, en l'isolant vis-à-vis d'éléments de l'environnement situés en vis-à-vis de la face externe de la plaque conductrice. En particulier, ce matériau isole électriquement la plaque conductrice par rapport au circuit de refroidissement. Cependant ce matériau contribue à l'échange thermique entre la plaque conductrice et le circuit de refroidissement.

Selon un mode de réalisation, l'équipement électrique forme un onduleur, ou un convertisseur de tension ou un chargeur électrique de batterie.

L'invention sera mieux comprise et d'autres détails, caractéristiques et avantages de l'invention apparaîtront à la lecture de la description suivante faite à titre d'exemple non limitatif en référence aux figures annexées dans lesquelles :
[Fig.1] représente un exemple de bloc capacitif selon un mode de réalisation de l'invention ;
[Fig.2] représente un élément capacitif du bloc capacitif de la figure 1 ;
[Fig.3] représente le bloc capacitif de la figure 1 sans le cadre ;
[Fig.4] représente le cadre du bloc capacitif de la figure 1 ;
[Fig.5] illustre une variante dans laquelle un film isolant supplémentaire est sur le cadre ;
[Fig.6] représente une vue de dessus du cadre ;
[Fig.7] représente un exemple d'équipement électrique selon un mode de réalisation de l'invention ;
[Fig.8] montre un exemple d'arc électrique qui est empêché dans l'équipement électrique de la figure 7 ;
[Fig.9] montre un exemple de ligne de fuite qui est empêché dans l'équipement électrique de la figure 7.

Il faut noter que les figures exposent un exemple selon l'invention de manière détaillée pour le mettre en œuvre, lesdites figures pouvant bien entendu servir à mieux définir l'invention le cas échéant.

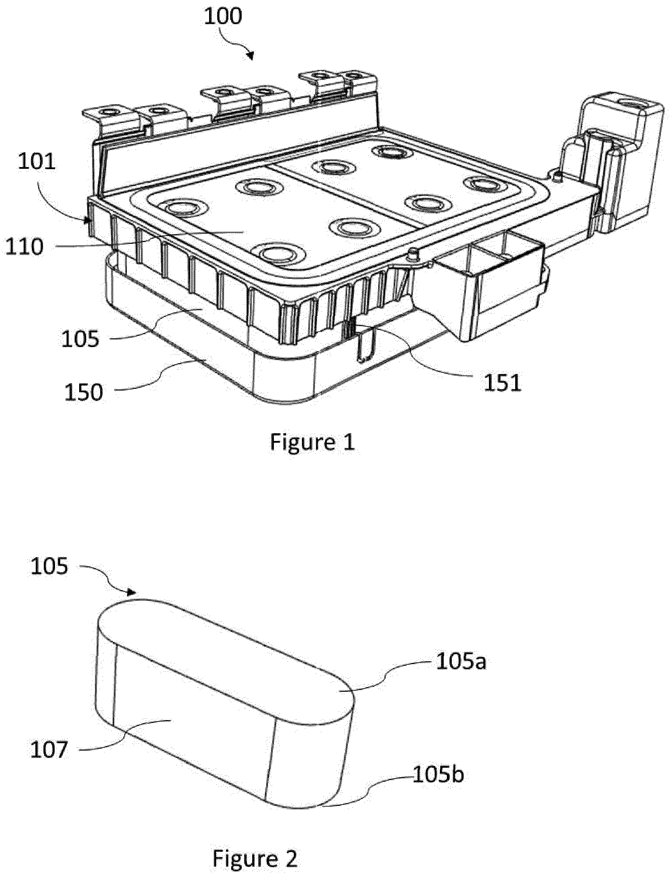

La figure 1 montre un bloc capacitif 100 selon un exemple de l'invention. Le bloc capacitif 100 comprend des éléments capacitifs 105. Un tel élément capacitif 105 est illustré en figure 2. L'élément capacitif 105 comprend notamment une électrode formée à une première extrémité 105a de l'élément capacitif 105. L'électrode peut s'étendre sur toute la première extrémité 105a. L'élément capacitif 105 comprend notamment un corps 107 qui protège l'élément capacitif 105. En particulier, le corps 107 peut être isolant électriquement. Une deuxième extrémité 105b opposée à la première extrémité 105a comprend une électrode de polarité opposée à l'électrode de la première extrémité 105a. L'électrode peut s'étendre sur toute la deuxième extrémité 105b. Alternativement, l'élément capacitif 105 pourrait avoir ses électrodes réunies sur une seule extrémité 105a, 105b. L'élément capacitif 105 est par exemple une capacité film. Le bloc capacitif 100 pourrait ne comprendre qu'un seul élément capacitif 105.

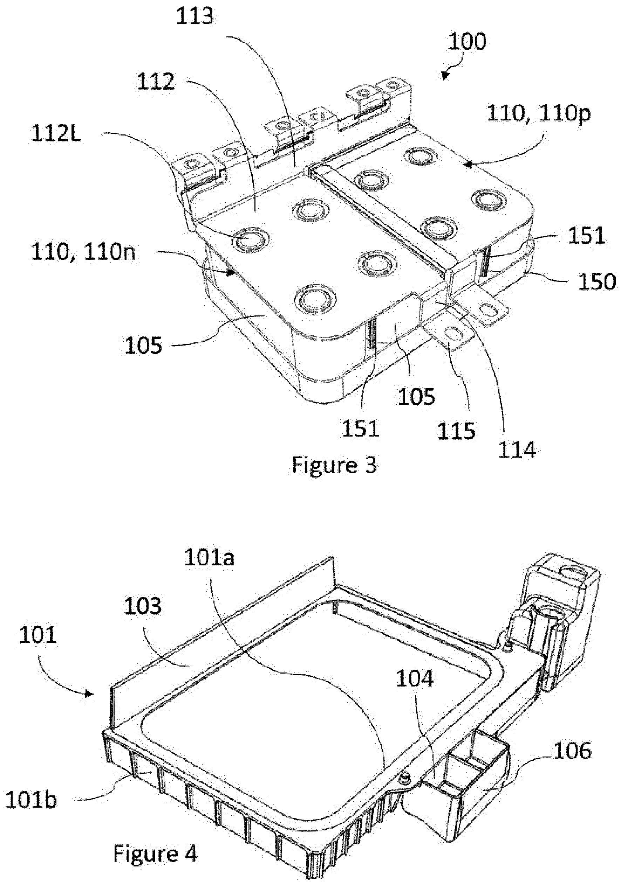

Le bloc capacitif 100 comprend en outre un premier conducteur électrique 110 comportant une plaque conductrice électrique 112 qui vient contre la première extrémité 105a de l'élément capacitif 105 pour y être connectée électriquement. Notamment, la plaque conductrice 112 vient contre l'électrode de la première extrémité 105a pour y être connectée. À cet effet la plaque 112 peut comprendre des languettes 112L, mieux visibles en figure 3, qui sont définies dans la plaque 112 pour venir être soudées sur la première extrémité 105a. Un vernis, notamment un vernis au silicone, peut être appliqué au niveau de la connexion entre les languettes 112L et la première extrémité 105a, mais aussi sur toute la surface de la première extrémité 105a, pour une protection contre l'humidité. Cependant, lorsque la première extrémité 105a est dépourvue d'électrode, la plaque conductrice peut venir contre la première extrémité 105a pour une mise à la masse du corps 107 de l'élément capacitif 105.

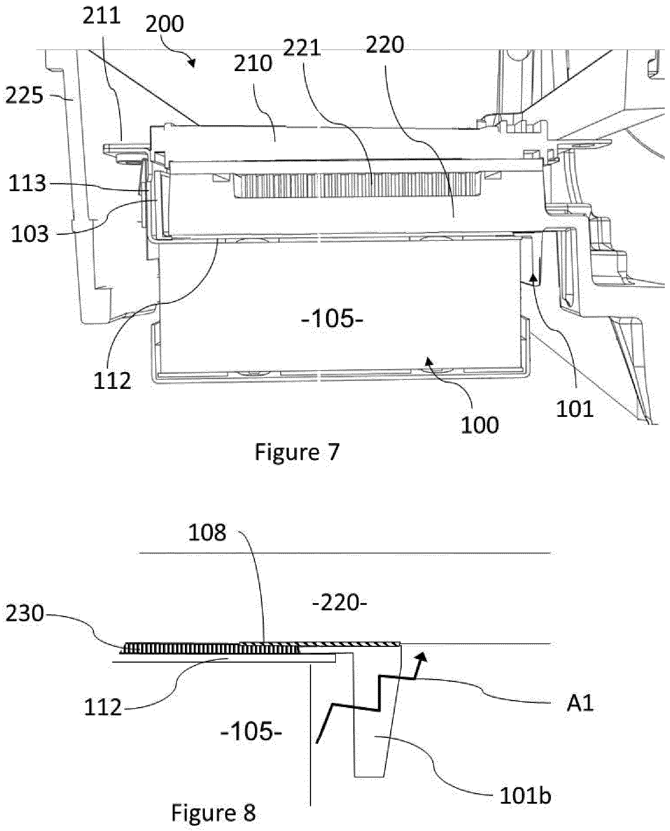

Le bloc capacitif 100 comprend également un premier cadre 101 en matériau isolant électrique, par exemple en plastique. Le cadre 101 vient en correspondance avec un bord périphérique de la plaque conductrice 112 de manière à isoler électriquement la plaque 112 par rapport à un environnement du bloc capacitif 100. Par exemple, comme illustré en figure 7 décrite plus loin, lorsque le bloc capacitif 100 est intégré dans un équipement électrique 200, le cadre 101 permet d'isoler électriquement la plaque conductrice 112 par rapport à un circuit de refroidissement 220 qui est à proximité du bloc capacitif 100.

La figure 4 représente le cadre 101 du bloc capacitif 100. Le cadre 101 comprend donc une ouverture centrale délimitée par un bord interne. Le cadre 101 comprend notamment une première portion 101a configurée pour venir contre une face de la plaque conductrice électrique 112. La première portion 101a vient en particulier contre la face de la plaque conductrice 112 qui est opposée à l'élément capacitif 105. En particulier, la première portion 101a comprend le bord interne du cadre 101.

Le cadre 101 peut comprendre en outre une deuxième portion 101b qui s'étend transversalement depuis la première portion 101a de manière à former une jupe 101b autour de la plaque conductrice 112. La jupe 101b contribue à l'isolation électrique de la plaque conductrice 112 vis-à-vis de son environnement. Notamment, la jupe 101b vient en vis-à-vis des bords de la plaque conductrice 112, et dépasse les bords de la plaque conductrice 112 vers la deuxième extrémité 105b de l'élément capacitif 105. Cependant, la jupe 101b n'atteint pas la deuxième extrémité 105b de l'élément capacitif 105. Ainsi, l'encombrement du bloc capacitif 100, notamment suivant une direction perpendiculaire à la jupe 101b, est limitée. Sur les figures, la hauteur de la jupe 101b, c'est-à-dire la distance entre le bord de la jupe 101b qui est liée à la première portion 101a et le bord extrémal de la jupe 101b, est inférieure à la moitié de la hauteur de l'élément capacitif 105. La hauteur de l'élément capacitif 105 est notamment la distance entre la première extrémité 105a et la deuxième extrémité 105b.

Comme illustré par exemple en figure 3, le bloc capacitif 100 peut comprendre des bornes électriques formées par des portions de connexion 113, 114 du premier conducteur 110. Les portions de connexion 113, 114 s'étendent depuis un bord périphérique de la plaque conductrice 112 dans une direction transversale par rapport à ladite plaque conductrice 112. En particulier, le premier conducteur 110 comprend une première portion de connexion 113 qui s'étend depuis la plaque conductrice 112 en s'éloignant de l'élément capacitif 105. La première portion de connexion 113 est par exemple configurée pour venir contre des bornes d'un module électronique de puissance, notamment dans un équipement électrique 200 décrit plus loin. Le premier conducteur électrique 110 peut comprendre une deuxième portion de connexion 114 qui s'étend depuis la plaque conductrice 112 en vis-à-vis de l'élément capacitif 105. La deuxième portion 114 est par exemple configurée pour venir contre un conducteur électrique pour connecter le bloc capacitif à une alimentation électrique.

Afin de protéger les portions de connexion 113, 114, le cadre 101 peut comprendre des portions de protection 103, 104 qui s'étendent le long des portions de connexion 113, 114 de manière à les protéger électriquement par rapport à l'environnement du bloc capacitif 100. En particulier, le cadre 101 comprend une première portion de protection 103 qui s'étend depuis la première portion 101a du cadre 101 dans une direction opposée à celle de la jupe formée par la deuxième portion 101b du cadre 101. La première portion de protection 103 s'étend en vis-à-vis d'une face de la première portion de connexion 113 afin de la recouvrir au moins partiellement. En particulier, la première portion de protection 113 et la première portion de connexion 103 se superposent suivant une direction perpendiculaire à ladite face de la première portion de connexion 113. Le cadre 101 comprend une deuxième portion de protection 104 formée par la jupe 101b. Les portions de protection 103, 104 permettent notamment une isolation électrique entre les portions de connexion 113, 114 et l'élément 200 à proximité, notamment en évitant la formation d'arc électrique à travers l'air ou la circulation d'un courant le long d'une ligne de fuite.

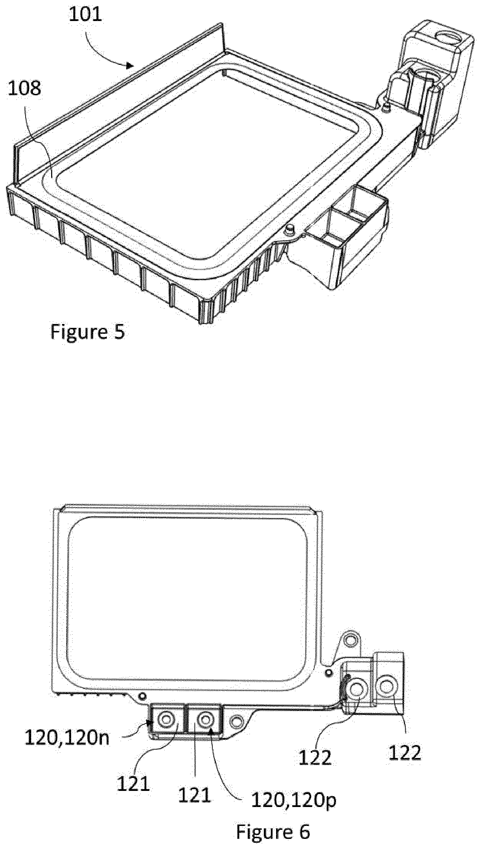

En faisant référence à la figure 6, le cadre 101 peut comprendre au moins un deuxième conducteur électrique 120 configuré pour venir sur le premier conducteur électrique 110 de manière à connecter le premier conducteur électrique 110 avec un composant électrique autre que l'élément capacitif 105, tel qu'un élément de filtrage d'une énergie électrique d'alimentation.

En particulier, le bloc capacitif 100 comprend un premier conducteur positif 110p et un premier conducteur négatif 110n. Les premiers conducteurs 110p, 110n sont notamment coplanaires sur une face du bloc capacitif 100 où se trouvent les premières extrémités 105a des éléments capacitifs 105. Le cadre 101 comprend un deuxième conducteur électrique positif 120p et un deuxième conducteur électrique négatif 120n qui se connectent respectivement au premier conducteur positif 110p et au premier conducteur négatif 110n. Les deuxièmes conducteurs électriques 120 sont donc intégrés dans le cadre 101. Les deuxièmes conducteurs électriques 120 sont par exemple maintenus par la matière du cadre 101 à l'aide de clips, ou par un montage en force, ou par surmoulage. Le premier cadre 101 sert donc en outre à connecter le premier conducteur 110 avec un composant électrique autre que l'élément capacitif 105, tel qu'un élément de filtrage d'une énergie électrique d'alimentation. En particulier, une extrémité 115 de la deuxième portion de connexion 114 est configurée pour venir sur une extrémité 121 du deuxième conducteur électrique 120 du cadre 101 pour une connexion électrique. Notamment, la zone de connexion entre les extrémités 115, 121 est entourée d'une paroi 106 intégrale avec la matière isolante du cadre 101, pour une protection électrique notamment.

Dans une variante illustrée en figure 5, un film isolant électrique 108 supplémentaire en forme de cadre vient continûment tout le long du bord interne du cadre 101 en s'étendant radialement vers l'intérieur du cadre 101, c'est-à-dire dans l'ouverture centrale du cadre 101. Le film isolant 108 permet notamment d'augmenter la ligne de fuite qui passe le long de la première portion 101a du cadre 101, et qui va de la plaque conductrice 112 à un élément à proximité du bloc capacitif 100, notamment le circuit de refroidissement 220 situé en vis-à-vis de la plaque conductrice qui sera décrit plus loin. Par exemple, le film isolant 108 est en polyester PET et/ou a une épaisseur de 200 micron, voire une épaisseur comprise entre 180 et 220 micron.

La figure 7 illustre un exemple d'équipement électrique 200 comprenant le bloc capacitif 100. L'équipement électrique 200 comprend en outre un module électronique de puissance 210 et un circuit de refroidissement 220. La plaque conductrice 112 du bloc capacitif 100 vient contre une face du circuit de refroidissement 220 et le module électronique de puissance 210 vient contre une face opposée du circuit de refroidissement 220. Le circuit de refroidissement comprend notamment un canal 221 situé entre le module électronique de puissance 210 et le bloc capacitif 100, dans lequel circule un liquide de refroidissement. En particulier, les composants 105, 200, 220 sont logés dans un boitier 225, dont seule une partie est visible en figure 7.

En particulier, la première portion de connexion 113 du premier conducteur 110 est directement connectée aux bornes électriques 211 du module électronique de puissance 210. A cet effet, la première portion de connexion 113 traverse un passage formé par un bord du circuit de refroidissement 220 et une paroi du boitier 225. La première portion de protection 103 du cadre 101 s'étend également dans ce passage entre la première portion de connexion 113 et le circuit de refroidissement 220. Ainsi, la première portion de protection 103 réalise une isolation électrique entre la première portion de connexion 103 et le circuit de refroidissement 220. La première portion de connexion évite notamment la formation d'un arc électrique dans l'air entre la première portion de connexion 113 et le circuit de refroidissement 220.

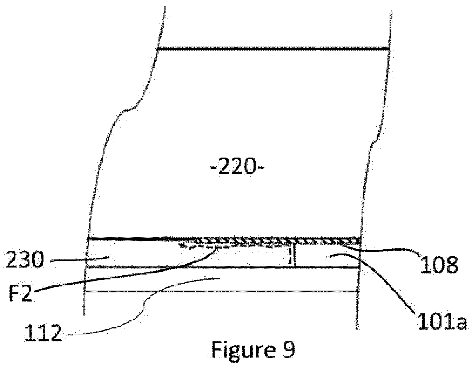

L'équipement électrique 200 comprend notamment une couche 230 de matériau isolant électriquement mais conducteur thermiquement, mieux visible en figures 8 et 9. Cette couche 230 est située entre le circuit de refroidissement 220 et la plaque conductrice 112. En particulier la couche 230 est un Gap Pad^{®}. La couche 230 de matériau est notamment ajustée par rapport à l'ouverture centrale du cadre 101, afin d'améliorer le contact entre le matériau 230 et la plaque conductrice 112, et ainsi améliorer la dissipation thermique entre la plaque conductrice 112 et le circuit de refroidissement 220.

La première partie 101a du cadre 101 a en outre une fonction de limitation de la compression de la couche de matériau 230. Par exemple, cette première partie 101a évite une compression de la couche de matériau 230 supérieure à 30% de l'épaisseur initiale de la couche 230. En particulier, l'épaisseur de la première partie 101a du cadre 101 est configurée pour éviter une telle compression de la couche 230. La première partie 101a du cadre 101 a par exemple une épaisseur de 0,8mm.

Comme illustré schématiquement en figure 8, le cadre 101, en particulier la jupe 101b, améliore l'isolation électrique entre la plaque conductrice 112 et le circuit de refroidissement 220 en évitant la formation d'un arc électrique A1 à travers l'air entre la plaque conductrice 112 et le circuit de refroidissement 220.

Comme illustré schématiquement en figure 9, le film isolant 108 améliore l'isolation électrique en augmentant la ligne de fuite F2 entre la plaque conductrice 112 et le circuit de refroidissement 220. Une telle ligne de fuite F2 part de la plaque conductrice 112, suit la frontière entre la couche de matériau 230 et la première partie 101a du cadre 101, puis la frontière entre la couche de matériau 230 et le film isolant 108, jusqu'au circuit de refroidissement 220. Il est plus avantageux de rajouter le film isolant 108 que d'augmenter le recouvrement entre la première portion 101a du cadre 101 car le film isolant 108 permet une meilleure dissipation thermique que le cadre 101.

Selon un mode de réalisation, en faisant référence aux figures 1 et 3, un logement 150 peut loger la deuxième extrémité 105b de l'élément capacitif 100 afin de recevoir un matériau de remplissage afin d'étanchéifier la deuxième extrémité 150b. Le matériau de remplissage est notamment un matériau isolant électrique, tel qu'une résine. En particulier, la première extrémité 105a est située hors dudit logement 150. Préalablement au remplissage du logement 150 par le matériau de remplissage, notamment par la résine en phase liquide, l'élément capacitif 105 est positionné dans ledit logement 150. Une entretoise 151 qui s'étend depuis un fond dudit logement 150 vient alors contre la plaque conductrice 112 qui forme une butée. L'entretoise 151 détermine alors la distance entre la première extrémité 105a de l'élément capacitif 105 et le fond dudit logement 105.

## Revendications

1. Bloc capacitif (100) comprenant :
au moins un élément capacitif (105),
un premier conducteur électrique (110) comprenant au moins une plaque conductrice électrique (112) venant contre une première extrémité (105a) de l'élément capacitif (105) de manière à être connectée électriquement avec l'élément capacitif (105)
un premier cadre (101) en matériau isolant électrique venant en correspondance avec un bord périphérique de la dite plaque conductrice (112) de manière à isoler électriquement ladite plaque (112) par rapport à un environnement du bloc capacitif (100)
et dans lequel ledit premier conducteur électrique (110) comporte au moins une portion de connexion (113, 114) s'étendant depuis un bord périphérique de ladite plaque conductrice (112) dans une direction transversale par rapport à ladite plaque conductrice (112), et dans lequel ledit premier cadre (101) comprend une portion de protection (103, 104) s'étendant vis-à-vis d'une face de ladite portion de connexion (113, 114) de manière à la protéger électriquement par rapport à un environnement du bloc capacitif (100).

2. Bloc capacitif (100) selon la revendication 1, dans lequel ledit premier cadre (101) comprend une première portion (101a) configurée pour venir contre une face de la plaque conductrice électrique (112) et une deuxième portion (101b) s'étendant transversalement depuis ladite première portion (101a) de manière à former une jupe (101b) autour de ladite plaque conductrice (112).

3. Bloc capacitif (100) selon la revendication 2, dans lequel la jupe (101b) s'étend sur une distance depuis la première portion (101a) du premier cadre (101) de sorte à éviter une circulation d'un courant à travers l'air entre la plaque conductrice (112) et un environnement du bloc capacitif (100).

4. Bloc capacitif (100) selon l'une des revendications précédentes, dans lequel le premier conducteur électrique (110) comprend une première portion de connexion (113) qui s'étend en s'éloignant de l'élément capacitif (105), et ledit premier cadre (101) comprend une première portion de protection (103) qui s'étend depuis la première portion (101a) du premier cadre (101) dans une direction opposée à celle de la jupe formée par la deuxième portion (101b) du premier cadre (101).

5. Bloc capacitif (100), selon l'une des revendications 2 et 3, dans lequel le premier conducteur électrique (110) comprend une deuxième portion de connexion (114) qui s'étend depuis la plaque conductrice (112) en vis-à-vis de l'élément capacitif (105), et ledit premier cadre (101) comprend une deuxième portion de protection (104) formée par au moins une partie de la jupe (101b).

6. Bloc capacitif (100) selon l'une des revendications précédentes, dans lequel ledit premier cadre (101) maintient au moins un deuxième conducteur électrique (120) configuré pour venir sur le premier connecteur électrique (110) de manière à connecter le premier conducteur électrique (110) avec un composant électrique autre que l'élément capacitif (105), notamment avec un élément de filtrage d'une énergie électrique d'alimentation.

7. Bloc capacitif (100) selon l'une des revendications précédentes, comprenant en outre un film isolant électrique (108) en forme de cadre, venant continûment tout le long du bord interne du premier cadre (101) et s'étendant radialement vers l'intérieur du premier cadre (101).

8. Bloc capacitif (100) selon l'une des revendications précédentes, dans lequel la plaque conductrice (112) vient contre au moins une électrode de l'élément capacitif (105) située à ladite première extrémité (105a) de l'élément capacitif (105) pour y être connectée électriquement.

9. Equipement électrique (200), notamment configuré pour être embarqué dans un véhicule, comprenant un bloc capacitif (100) selon l'une des revendications précédentes, un module électronique de puissance (210) et un circuit de refroidissement (220) ; la plaque conductrice (112) du bloc capacitif (100) venant contre une face du circuit de refroidissement (220), le module électronique de puissance (210) venant contre une face opposée du circuit de refroidissement (220).

10. Equipement électrique (200) selon la revendication 9, comprenant un bloc capacitif (100) selon la revendication 4, dans lequel la première portion de connexion (113) se connecte directement aux bornes électriques (211) du module électronique de puissance (220), en passant dans un passage formé au moins en partie par un bord du circuit de refroidissement (220),
et dans lequel la première portion de protection (103) dudit premier cadre (101) s'étend dans ledit passage entre ladite première portion de connexion (113) et ledit circuit de refroidissement (220).

11. Equipement électrique (200) selon la revendication 9 ou 10, comprenant une couche de matériau (230) isolant électriquement mais conducteur thermiquement entre le circuit de refroidissement (220) et la plaque conductrice (112), ladite couche de matériau (230) venant dans l'ouverture centrale du premier cadre (101).

## Patentansprüche

1. Kapazitiver Block (100), umfassend:
mindestens ein kapazitives Element (105),
einen ersten elektrischen Leiter (110), der mindestens eine elektrisch leitende Platte (112) umfasst, die gegen ein erstes Ende (105a) des kapazitiven Elements (105) anliegt, um elektrisch mit dem kapazitiven Element (105) verbunden zu sein,
einen ersten Rahmen (101) aus elektrisch isolierendem Material, der mit einem Umfangsrand der besagten leitenden Platte (112) korrespondiert, um die besagte Platte (112) gegenüber einer Umgebung des kapazitiven Blocks (100) elektrisch zu isolieren,
und wobei der besagte erste elektrische Leiter (110) mindestens einen Verbindungsabschnitt (113, 114) aufweist, der sich von einem Umfangsrand der besagten leitenden Platte (112) in einer Querrichtung bezüglich der besagten leitenden Platte (112) erstreckt, und wobei der besagte erste Rahmen (101) einen Schutzabschnitt (103, 104) umfasst, der sich gegenüber einer Fläche des besagten Verbindungsabschnitts (113, 114) erstreckt, um diesen elektrisch gegenüber einer Umgebung des kapazitiven Blocks (100) zu schützen.

2. Kapazitiver Block (100) nach Anspruch 1, wobei der besagte erste Rahmen (101) einen ersten Abschnitt (101a), der konfiguriert ist, um gegen eine Fläche der elektrisch leitenden Platte (112) anzuliegen, und einen zweiten Abschnitt (101b) umfasst, der sich quer vom besagten ersten Abschnitt (101a) erstreckt, um einen Schurz (101b) um die besagte leitende Platte (112) zu bilden.

3. Kapazitiver Block (100) nach Anspruch 2, wobei sich der Schurz (101b) über eine Distanz vom ersten Abschnitt (101a) des ersten Rahmens (101) erstreckt, um eine Stromleitung durch die Luft zwischen der leitenden Platte (112) und einer Umgebung des kapazitiven Blocks (100) zu verhindern.

4. Kapazitiver Block (100) nach einem der vorhergehenden Ansprüche, wobei der erste elektrische Leiter (110) einen ersten Verbindungsabschnitt (113) umfasst, der sich vom kapazitiven Element (105) weg erstreckt, und der besagte erste Rahmen (101) einen ersten Schutzabschnitt (103) umfasst, der sich vom ersten Abschnitt (101a) des ersten Rahmens (101) in eine Richtung erstreckt, die der Richtung des durch den zweiten Abschnitt (101b) des ersten Rahmens (101) gebildeten Schurzes entgegengesetzt ist.

5. Kapazitiver Block (100) nach einem der Ansprüche 2 und 3, wobei der erste elektrische Leiter (110) einen zweiten Verbindungsabschnitt (114) umfasst, der sich von der leitenden Platte (112) gegenüber dem kapazitiven Element (105) erstreckt, und der besagte erste Rahmen (101) einen zweiten Schutzabschnitt (104) umfasst, der durch mindestens einen Teil des Schurzes (101b) gebildet wird.

6. Kapazitiver Block (100) nach einem der vorhergehenden Ansprüche, wobei der besagte erste Rahmen (101) mindestens einen zweiten elektrischen Leiter (120) hält, der konfiguriert ist, um auf den ersten elektrischen Anschluss (110) zu kommen, um den ersten elektrischen Leiter (110) mit einer anderen elektrischen Komponente als dem kapazitiven Element (105) zu verbinden, insbesondere mit einem Filterelement einer elektrischen Versorgungsenergie.

7. Kapazitiver Block (100) nach einem der vorhergehenden Ansprüche, ferner umfassend einen elektrisch isolierenden Film (108) in Rahmenform, der kontinuierlich entlang der Innenkante des ersten Rahmens (101) verläuft und sich radial nach innen des ersten Rahmens (101) erstreckt.

8. Kapazitiver Block (100) nach einem der vorhergehenden Ansprüche, wobei die leitende Platte (112) gegen mindestens eine Elektrode des kapazitiven Elements (105) anliegt, die sich am besagten ersten Ende (105a) des kapazitiven Elements (105) befindet, um dort elektrisch verbunden zu sein.

9. Elektrische Ausrüstung (200), insbesondere konfiguriert, um in einem Fahrzeug eingebaut zu werden, umfassend einen kapazitiven Block (100) nach einem der vorhergehenden Ansprüche, ein elektronisches Leistungsmodul (210) und einen Kühlkreislauf (220); wobei die leitende Platte (112) des kapazitiven Blocks (100) gegen eine Fläche des Kühlkreislaufs (220) anliegt, wobei das elektronische Leistungsmodul (210) gegen eine gegenüberliegende Fläche des Kühlkreislaufs (220) anliegt.

10. Elektrische Ausrüstung (200) nach Anspruch 9, umfassend einen kapazitiven Block (100) nach Anspruch 4, wobei der erste Verbindungsabschnitt (113) direkt mit den elektrischen Anschlüssen (211) des elektronischen Leistungsmoduls (220) verbunden ist, indem er durch einen Durchgang verläuft, der zumindest teilweise durch einen Rand des Kühlkreislaufs (220) gebildet wird,
und wobei der erste Schutzabschnitt (103) des besagten ersten Rahmens (101) sich in den besagten Durchgang zwischen den besagten ersten Verbindungsabschnitt (113) und den besagten Kühlkreislauf (220) erstreckt.

11. Elektrische Ausrüstung (200) nach Anspruch 9 oder 10, umfassend eine Schicht aus Material (230), das elektrisch isolierend, aber thermisch leitend ist, zwischen dem Kühlkreislauf (220) und der leitenden Platte (112), wobei die besagte Materialschicht (230) in die zentrale Öffnung des ersten Rahmens (101) kommt.

## Claims

1. Capacitive block (100) comprising:
at least one capacitive element (105),
a first electrical conductor (110) comprising at least one electrically conductive plate (112) positioned against a first end (105a) of the capacitive element (105) so as to be electrically connected with the capacitive element (105)
a first frame (101) made of electrically insulating material positioned in correspondence with a peripheral edge of said conductive plate (112) so as to electrically insulate said plate (112) from an environment of the capacitive block (100)
and wherein said first electrical conductor (110) includes at least one connection portion (113, 114) extending from a peripheral edge of said conductive plate (112) in a transverse direction relative to said conductive plate (112), and wherein said first frame (101) comprises a protection portion (103, 104) extending opposite a face of said connection portion (113, 114) so as to electrically protect it from an environment of the capacitive block (100).

2. Capacitive block (100) according to claim 1, wherein said first frame (101) comprises a first portion (101a) configured to come against a face of the electrically conductive plate (112) and a second portion (101b) extending transversely from said first portion (101a) so as to form a skirt (101b) around said conductive plate (112).

3. Capacitive block (100) according to claim 2, wherein the skirt (101b) extends over a distance from the first portion (101a) of the first frame (101) so as to prevent a current flow through the air between the conductive plate (112) and an environment of the capacitive block (100).

4. Capacitive block (100) according to any one of the preceding claims, wherein the first electrical conductor (110) comprises a first connection portion (113) that extends away from the capacitive element (105), and said first frame (101) comprises a first protection portion (103) that extends from the first portion (101a) of the first frame (101) in a direction opposite to that of the skirt formed by the second portion (101b) of the first frame (101).

5. Capacitive block (100), according to any one of claims 2 and 3, wherein the first electrical conductor (110) comprises a second connection portion (114) that extends from the conductive plate (112) opposite the capacitive element (105), and said first frame (101) comprises a second protection portion (104) formed by at least a part of the skirt (101b).

6. Capacitive block (100) according to any one of the preceding claims, wherein said first frame (101) holds at least a second electrical conductor (120) configured to come on the first electrical connector (110) so as to connect the first electrical conductor (110) with an electrical component other than the capacitive element (105), particularly with a filtering element of an electrical power supply.

7. Capacitive block (100) according to any one of the preceding claims, further comprising an electrically insulating film (108) in the form of a frame, coming continuously along the entire inner edge of the first frame (101) and extending radially inward from the first frame (101).

8. Capacitive block (100) according to any one of the preceding claims, wherein the conductive plate (112) comes against at least one electrode of the capacitive element (105) located at said first end (105a) of the capacitive element (105) to be electrically connected thereto.

9. Electrical equipment (200), particularly configured to be on board a vehicle, comprising a capacitive block (100) according to any one of the preceding claims, a power electronic module (210) and a cooling circuit (220); the conductive plate (112) of the capacitive block (100) coming against a face of the cooling circuit (220), the power electronic module (210) coming against an opposite face of the cooling circuit (220).

10. Electrical equipment (200) according to claim 9, comprising a capacitive block (100) according to claim 4, wherein the first connection portion (113) connects directly to the electrical terminals (211) of the power electronic module (220), passing through a passage formed at least in part by an edge of the cooling circuit (220),
and wherein the first protection portion (103) of said first frame (101) extends in said passage between said first connection portion (113) and said cooling circuit (220).

11. Electrical equipment (200) according to claim 9 or 10, comprising a layer of material (230) that is electrically insulating but thermally conductive between the cooling circuit (220) and the conductive plate (112), said layer of material (230) coming into the central opening of the first frame (101).
